# FASCICULE DE BREVET EUROPEEN

(11) **EP 1 267 413 B1**
(45) Date de publication et mention de la délivrance du brevet: **11.01.2006**
(21) Numéro de dépôt: 02354096.6
(22) Date de dépôt: 14.06.2002
(51) Int. Cl.: H01L 29/417, H01L 29/06

(54) **Transistor MOS de puissance latéral**
Laterales Leistungs-MOSFET
Lateral power MOSFET

(30) Priorité: 15.06.2001 FR 0107870
(43) Date de publication de la demande: 18.12.2002
(73) Titulaire: STMicroelectronics, 92120 Montrouge (FR)
(72) Inventeur: Mattei, Sandra, Résidence Jardin des Facultés, 13005 Marseille (FR); Germana, Rosalia, 13790 Rousset (FR)
(74) Mandataire: de Beaumont, Michel

(56) Documents cités:
- DE-A- 19 801 095
- US-A- 4 794 432
- US-A- 5 514 608
- US-A- 5 760 440
- US-A- 6 011 278

## Description

La présente invention concerne des transistors MOS de moyenne puissance.

Dans le domaine des transistors MOS de moyenne puissance, on connaît des structures de type vertical dans lesquelles la source est du côté de la face avant et le drain du côté de la face arrière, et des structures de type latéral dans lesquelles la source et le drain sont du côté de la face avant. De façon générale, quand le courant à commuter est relativement important, on préfère les transistors de type vertical pour minimiser les résistances d'accès.

En effet, comme on va le montrer ci-après, les structures de type latéral posent un problème lié aux résistances des métallisations d'accès à la source et/ou au drain.

Néanmoins, les structures latérales sont souvent plus faciles à réaliser et technologiquement plus simples.

Le document US-A-4 794 432 décrit un transistor Mos de puissance latéral avec des caractéristiques améliorées de tension de claquage.

Ainsi, un objet de la présente invention est de prévoir une structure de transistor MOS de moyenne puissance de type latéral dans laquelle les résistances d'accès au drain et à la source sont réduites.

Un objet plus particulier de la présente invention est de prévoir un tel transistor de type à canal P.

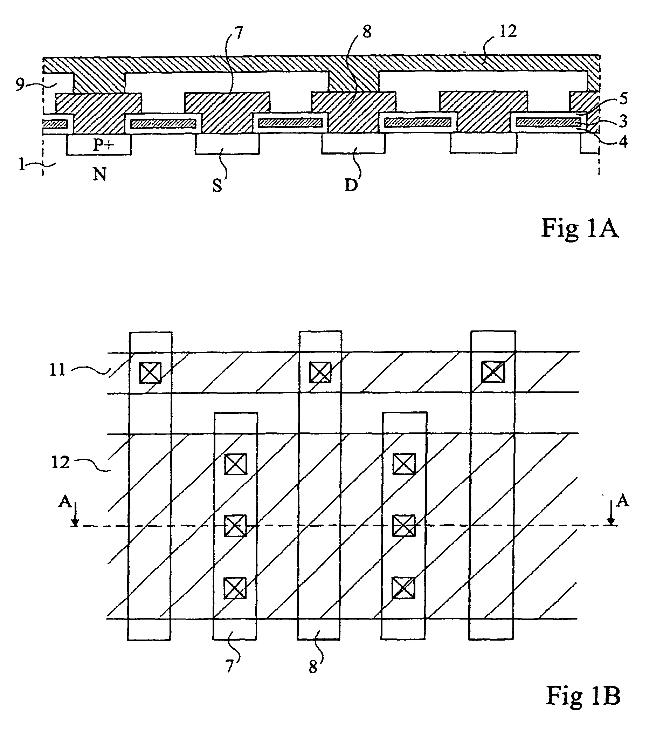

Les figures 1A et 1B illustrent respectivement une vue en coupe et une vue de dessus schématique d'un transistor MOS à canal P classique de type latéral. La figure 1A est une vue en coupe selon la ligne A-A de la figure 1B. On notera qu'aucune de ces figures n'est à l'échelle par rapport à un dispositif réel et que ces figures ne sont pas à l'échelle l'une par rapport à l'autre, comme cela est classique dans le domaine de la représentation des composants semiconducteurs.

Le transistor MOS à canal P des figures 1A et 1B est réalisé dans un substrat semiconducteur 1 de type N, généralement une couche épitaxiée formée au-dessus d'une tranche de silicium monocristallin de type N⁺. Au-dessus de ce substrat sont formés des doigts de grille 3 séparés du substrat par une couche isolante mince 4. De façon classique, les doigts de grille sont en silicium polycristallin et l'isolant de grille est de l'oxyde de silicium. Les doigts de grille sont interconnectés et reliés à une borne de grille d'une façon non représentée. Les doigts de grille sont revêtus et entourés latéralement d'une couche isolante 5, également généralement en oxyde de silicium. Ces doigts de grille servent de masque pour la formation dans le substrat 1 de régions fortement dopées de type P. Ces régions P correspondent alternativement à des doigts de source S et à des doigts de drain D. Chacun des doigts de source et des doigts de drain est revêtu d'un doigt de métal, respectivement 7 et 8. Les doigts de métal sont gravés dans un premier niveau de métallisation. La structure est recouverte d'une couche isolante 9 dans laquelle sont formées des ouvertures pour permettre d'établir des contacts entre une métallisation de source 11 et les doigts de métal de source 7 et entre une métallisation de drain 12 et les doigts de drain 8. Les métallisations de source et de drain sont gravées dans un deuxième niveau de métallisation. Seule la métallisation de drain 12 est visible dans la vue en coupe de la figure 1A.

Dans la vue de dessus de la figure 1B, on a représenté la métallisation de source 11 en contact avec des prolongements des doigts de source 8. La métallisation de drain recouvre sensiblement l'ensemble des doigts de drain et de source et est en contact avec les doigts de drain. Les zones de contact entre les premier et deuxième niveaux de métallisation sont indiquées en figure 1B par des carrés marqués d'une croix. Quelle que soit la topologie choisie pour le deuxième niveau de métallisation, on notera qu'au moins pour les doigts de drain ou les doigts de source, il existe une certaine longueur du premier niveau de métallisation entre le contact avec la deuxième métallisation et l'extrémité de chaque doigt et cette longueur correspond à une résistance d'accès.

Un des aspects de la présente invention a été de prendre conscience de l'existence de cette résistance d'accès et de sa valeur. Si on considère que les doigts de métal de drain et de source ont une largeur de 1 µm et sont distants les uns des autres de 1 µm, c'est-à-dire que pour un carré d'un millimètre de côté, on aura environ 250 doigts de source et 250 doigts de drain, et en supposant que le premier niveau de métal a une résistance de couche de 60 mΩ/carré, ceci signifie qu'une bande de 1 mm de long et de 1 µm de large a une résistance de 60 Ω. Pour un carré de 1 mm de côté comprenant 250 doigts, la résistance sera de 60/250 Ω ou 240 mΩ, ou en d'autres termes 240 mΩ.mm². Dans une technologie courante, cette résistance est plus élevée que la résistance à l'état passant de la zone de canal proprement dite qui est de l'ordre de 50 mΩ.mm².

Dans l'exemple de structure de la figure 1B, cette résistance de métal est essentiellement liée aux doigts de source. Le contact entre le niveau de métallisation et les doigts de drain est par contre très satisfaisant.

La présente invention vise à réduire cette résistance d'accès à un transistor MOS latéral à doigts multiples.

Pour atteindre cet objet, la présente invention prévoit un transistor MOS de puissance formé dans une couche épitaxiée d'un premier type de conductivité, elle-même formée sur la face avant d'un substrat fortement dopé du premier type de conductivité, comprenant une pluralité de doigts de drain et de source alternés du deuxième type de conductivité séparés par un canal, des doigts conducteurs recouvrant chacun des doigts de source et des doigts de drain, un deuxième niveau de métal reliant tous les doigts de métal de drain et recouvrant sensiblement l'ensemble de la structure de source-drain. Chaque doigt de source comporte une zone fortement dopée du premier type de conductivité en contact avec la couche épitaxiée et avec le doigt de source correspondant, et la face arrière du substrat est revêtue d'une métallisation de source.

Selon un mode de réalisation de la présente invention, la zone fortement dopée du premier type de conductivité de chaque doigt de source s'étend sensiblement sur la longueur du doigt de source.

Selon un mode de réalisation de la présente invention, la zone fortement dopée du premier type de conductivité de chaque doigt de source s'étend sur des zones choisies de la longueur du doigt de source.

Un avantage de la présente invention est que, dans le cas plus particulier d'un transistor MOS à canal P, la structure décrite est bien compatible avec des technologies de fabrication existantes et les substrats couramment utilisés (couche épitaxiée de type N sur substrat N⁺).

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A et 1B sont respectivement une vue en coupe et une vue de dessus d'un transistor MOS latéral classique ;
les figures 2A et 2B sont respectivement une vue en coupe et une vue de dessus d'un transistor MOS selon la présente invention.

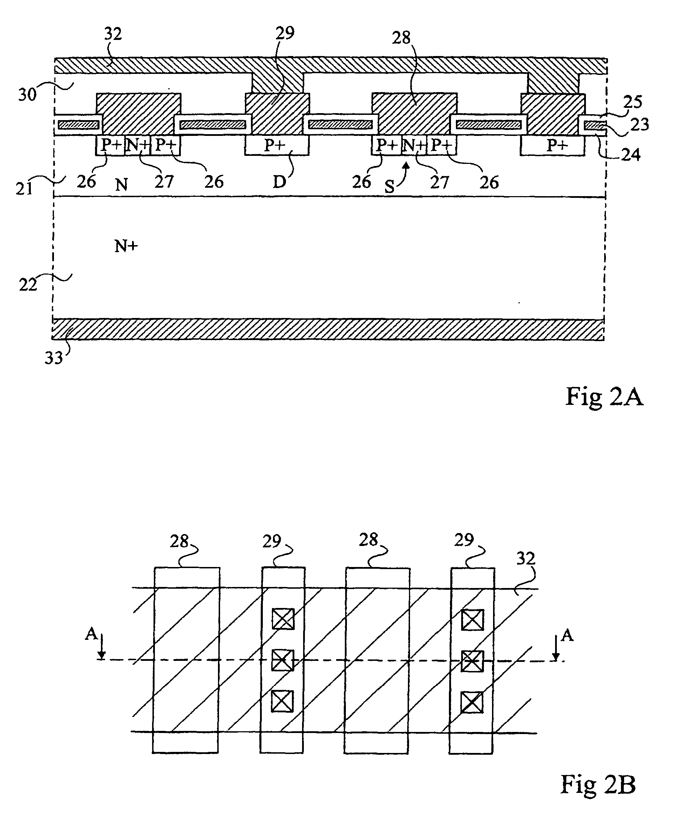

Les figures 1A et 2A sont respectivement des vues en coupe selon les lignes A-A des figures 1B et 2B.

De façon usuelle dans le domaine de la représentation semiconducteur, aucune des figures n'est à l'échelle par rapport à un composant réel. De plus les figures ne sont pas à l'échelle entre elles.

En figures 2A et 2B, un transistor MOS latéral à canal P est formé dans une couche épitaxiée 21 de type N formé sur un substrat 22 de type N⁺. Le transistor comprend des doigts de grille interconnectés 23 formés au-dessus d'un isolant mince 24 et entouré d'une couche isolante 25. Dans la couche épitaxiée, entre les doigts de grille, on trouve des régions de type P fortement dopées correspondant alternativement à des doigts de drain D et des doigts de source S. Chaque doigt de source S comprend d'une part une région de type P⁺ 26 fortement dopée constituant le doigt de source proprement dit et d'autre part une ou plusieurs régions 27 de type N⁺ en contact avec le substrat. Ces régions 27 peuvent être situées sensiblement au centre des doigts de source 26 et être continues sur toute la longueur de chacun des doigts de source ou être localisées dans ces doigts.

Des doigts de métal de source 28 formés au-dessus des doigts de source sont en contact avec les régions de source proprement dites 26 de type P⁺ et avec les régions 27 dopées de type de conductivité opposé. Des doigts de métal de drain 29 sont formés au-dessus des doigts de drain. Les doigts de métal 28 et 29 sont gravés à partir d'un premier niveau de métallisation. Les doigts de métal de source 28 sont exempts de toute connexion externe et servent seulement à établir un court-circuit entre les régions 26 et 27. Une couche isolante 30 est déposée au-dessus de la structure et une métallisation supérieure 32 est en contact avec tous les doigts de métal de drain 29.

La face arrière du substrat est recouverte d'une métallisation 33 et constitue une métallisation de source et est connectée au potentiel auquel doit être connectée la source, c'est-à-dire un potentiel positif dans le cas d'un transistor MOS à canal P.

Ainsi, quand la grille 23 du transistor MOS est convenablement polarisée, c'est-à-dire au potentiel de la masse dans le cas d'un transistor à canal P, un courant circule de la métallisation de source 33 par l'intermédiaire du substrat 22 et de la couche épitaxiée 21 vers les régions N⁺ 27. Par l'intermédiaire de doigts de métal 28, le courant passe par les régions 26 puis par les régions de canal des transistors vers les régions de drain D, les doigts de métal de drain 29 et la métallisation de drain 32.

Dans cette structure, la résistance d'accès au drain est aussi faible que dans le cas de la structure des figures 1A et 1B. Par contre la résistance d'accès à la source est beaucoup plus faible que dans le cas de la structure des figures 1A et 1B. En effet, à titre d'exemple, pour une couche épitaxiée d'une épaisseur de l'ordre de 3 µm et d'un niveau de dopage de 4x10¹⁶ atomes/cm³, on obtient une résistance dans la couche épitaxiée 21 entre la tranche 22 et chaque région 27 qui est seulement de l'ordre de 15 mΩ.mm², c'est-à-dire environ 16 fois plus faible que dans le cas de la structure classique des figures 1A et 1B. Le fonctionnement du transistor MOS reste en ce qui concerne son canal un fonctionnement de type transistor latéral entre doigts de source et doigts de drain bien que la conduction de la métallisation de source vers les doigts de source soit verticale. On pourra ainsi qualifier le transistor selon la présente invention de transistor semilatéral.

La présente invention est susceptible de nombreuses variantes et modifications qui apparaîtront à l'homme de l'art, notamment en ce qui concerne la réalisation de chacun des doigts de drain et de source qui pourra utiliser toute technologie connue. On pourra par exemple réaliser des structures à espaceurs pour obtenir des drains de type LDD.

Tous les types de conductivité pourront être inversés pour réaliser des transistors à canal N.

Les régions N⁺ 27 formées dans chaque doigt de source 26 pourront être plus profondes que les régions P⁺ 26 de ces doigts. Ainsi, les régions P⁺ 26 seront de préférence réalisées après les régions N⁺ 27 pour réduire les recuits auxquels elles sont soumises.

## Revendications

1. Transistor MOS de puissance formé dans une couche épitaxiée (21) d'un premier type de conductivité, elle-même formée sur la face avant d'un substrat (22) fortement dopé du premier type de conductivité, comprenant une pluralité de doigts de drain (D) et de source (S) alternés du deuxième type de conductivité séparés par un canal susceptible de se former dans ladite couche épitaxiée, des doigts conducteurs (28, 29) recouvrant chacun des doigts de source et des doigts de drain, un deuxième niveau de métal (32) reliant tous les doigts de métal de drain et recouvrant sensiblement l'ensemble de la structure de source-drain, chaque doigt de source (26) comportant une zone (27) fortement dopée du premier type de conductivité en contact avec la couche épitaxiée (21) et avec le doigt de source (28) correspondant, et la face arrière du substrat étant revêtue d'une métallisation de source (33).

2. Transistor MOS selon la revendication 1, **caractérisé en ce que** la zone fortement dopée (27) du premier type de conductivité de chaque doigt de source s'étend sensiblement sur la longueur du doigt de source.

3. Transistor MOS selon la revendication 1, **caractérisé en ce que** la zone fortement dopée (27) du premier type de conductivité de chaque doigt de source s'étend sur des zones choisies de la longueur du doigt de source.

## Claims

1. A MOS power transistor formed in an epitaxial layer (21) of a first conductivity type, the epitaxial layer being formed on the front surface of a heavily-doped substrate (22) of the first conductivity type, including a plurality of alternate drain (D) and source (S) fingers of the second conductivity type separated by channels capable of being formed in said epitaxial layer, conductive fingers (28, 29) covering each of the source fingers and of the drain fingers, a second metal level (32) connecting all the drain metal fingers and substantially covering the entire source-drain structure, each source finger (26) including a heavily-doped area (27) of the first conductivity type in contact with the epitaxial layer (21) and with the corresponding source finger (28), and the rear surface of the substrate being coated with a source metallization (33).

2. The MOS transistor of claim 1, wherein the heavily-doped area (27) of the first conductivity type of each source finger extends substantially over the length of the source finger.

3. The MOS transistor of claim 1, wherein the heavily-doped area (27) of the first conductivity type of each source finger extends over selected areas of the source finger length.

## Patentansprüche

1. Ein MOS-Leistungstransistor, der in einer Epitaxialschicht (21) eines ersten Leitfähigkeitstyps ausgebildet ist, wobei die Epitaxialschicht auf der Vorderseite eines stark dotierten Substrats (22) des ersten Leitfähigkeitstyps ausgebildet ist, wobei der Transistor Folgendes aufweist: Eine Vielzahl von abwechselnden bzw. alternierenden Drain- (D) und Source-(S)-Fingern des zweiten Leitfähigkeitstyps, die durch Kanäle von einander getrennt sind, die in der Lage sind, in der Epitaxialschicht ausgebildet zu sein,
leitende Finger (28, 29), welche jeden der Source-Finger und der Drain-Finger abdecken,
eine zweite Metallebene (32), das alle Drain-Metallfinger miteinander verbindet und im Wesentlichen die gesamte Source-Drain-Struktur abdeckt, wobei jeder Source-Finger (26) einen stark dotierten Bereich (27) des ersten Leitfähigkeitstyps besitzt, der in Kontakt mit der Epitaxialschicht (21) steht, und wobei der entsprechende Source-Finger (28) und die Rückseite des Substrats mit einer Source-Metallisierung (33) beschichtet sind.

2. MOS-Transistor nach Anspruch 1, wobei der stark dotierte Bereich (27) des ersten Leitfähigkeitstyps jedes Source-Fingers sich im Wesentlichen über die Länge des Source-Fingers erstreckt.

3. MOS-Transistor nach Anspruch 1, wobei der stark dotierte Bereich (27) des ersten Leitfähigkeitstyps jedes Source-Fingers sich über ausgewählte Bereiche der Source-Finger-Länge erstreckt.
